# EUROPEAN PATENT APPLICATION

(11) **EP 4 738 061 A1**
(43) Date of publication of application: **06.05.2026**
(21) Application number: 25205464.8
(22) Date of filing: 29.09.2025
(51) Int. Cl.: G06F 1/185, H01R 12/57, H01R 12/72, H01R 12/73, H01R 13/6471, H05K 1/02, H05K 1/11

(54) **EDGE MOUNT MEMORY CONNECTOR FOOTPRINT**

(30) Priority: 04.11.2024 US 202418936212
(71) Applicant: INTEL Corporation, Santa Clara, CA 95054 (US)
(72) Inventor: HANKS, Landon, Milwaukie, OR, 97267 (US)
(74) Representative: Rummler, Felix

(57) **Abstract**

A dual inline memory module (DIMM) connector has pins to connect to pad footprints and signal routing that reduces crosstalk and noise. The shape and placement of ground pads and signal pads can improve grounding of noise signals and improve the signal isolation on the signal pins. The ground pads can have additional ground vias to increase the ground path to the ground plane.

## Description

### FIELD

Descriptions are generally related to memory systems, and more particular descriptions are related to memory module interconnects.

### BACKGROUND

DDR (double data rate) memory is an important element to the compute system to provide data and code for the compute applications. The increasing speed of operation increases the demand for high-speed memory bandwidth and increased memory throughput.

DDR memory can be provided to a computing device with memory modules, such as DIMMs (dual inline memory modules). A DIMM represents one type of surface mount memory module, and there can be other types of surface mount memory modules connected to the pads on the system board with a connector.

The connectors and the footprint of the pads corresponding to the pins on the connectors provide the memory channel interconnect. The signaling through the connectors, the pins, and the surface mount pads is increasingly burdened with increasingly higher signaling speeds. The signaling can be burdened by routing constraints as pins are moved closer together and more ground vias are used. The signaling can also be burdened by connector pin and surface mount pad impedance that reduce signal integrity. The signaling can also be burdened by increased crosstalk between adjacent signals, especially as pin and pad separation is reduced.

### BRIEF DESCRIPTION OF THE DRAWINGS

The following description includes discussion of figures having illustrations given by way of example of an implementation. The drawings should be understood by way of example, and not by way of limitation. As used herein, references to one or more examples are to be understood as describing a particular feature, structure, or characteristic included in at least one implementation of the invention. Phrases such as "in one example" or "in an alternative example" appearing herein provide examples of implementations of the invention, and do not necessarily all refer to the same implementation. However, they are also not necessarily mutually exclusive.
**Figure 1** is a block diagram of an example of a system with memory module pads and routing for improved memory signaling.
**Figure 2A** is a block diagram of an example of a ground pad footprint.
**Figure 2B** is a diagram of an example of a ground pin foot for the ground pad footprint of Figure 2A.
**Figure 3A** is a block diagram of an example of a reduced length ground pad footprint and signal footprint.
**Figure 3B** is a diagram of an example of a ground pin foot for the ground pad footprint and signal pin foot for the signal pad footprint of Figure 3A.
**Figure 3C** is a diagram of an example of a DIMM connector with pins turned under the connector housing.
**Figure 4A** is a block diagram of an example of a reduced length ground pad footprint and signal footprint with capacitive stubs.
**Figure 4B** is a diagram of an example of a ground pin foot for the ground pad footprint and signal pin foot for the signal pad footprint of Figure 4A.
**Figure 4C** is a diagram of an example of a cutaway view of Figure 4B.
**Figure 5** is a block diagram of an example of a memory subsystem in which a DIMM connector can be implemented.
**Figure 6** is a block diagram of an example of a computing system in which a DIMM connector can be implemented.
**Figure 7** is a block diagram of an example of a multi-node network in which a DIMM connector can be implemented.

Descriptions of certain details and implementations follow, including non-limiting descriptions of the figures, which may depict some or all examples, and well as other potential implementations.

### DETAILED DESCRIPTION

As described herein, a surface mount memory module connector has pins and corresponding surface mount pad footprint that reduces crosstalk and noise. The shape and placement of ground pads and signal pads can improve grounding of noise signals and improve the signal isolation on the signal pins, increasing signal integrity. The connector footprint can also improve signal routing options. The ground pads can have additional ground vias to increase the ground path to the ground plane.

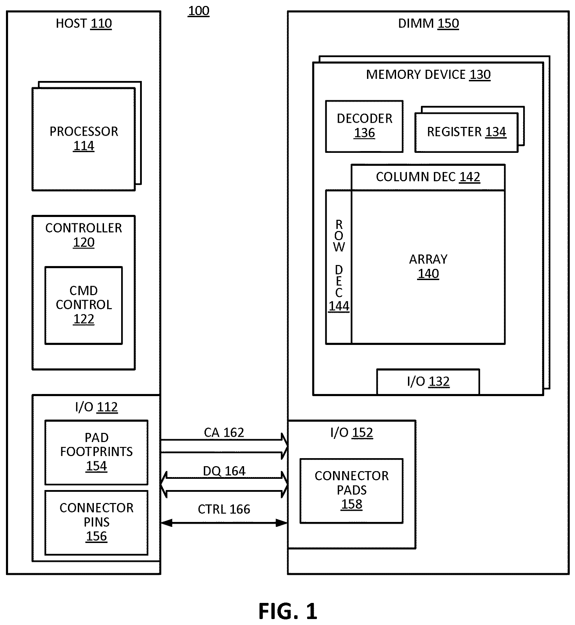

**Figure 1** is a block diagram of an example of a system with memory module pads and routing for improved memory signaling. System 100 includes host 110 with processor 114 and controller 120. Controller 120 can be a memory controller. In one example, controller 120 is an integrated memory controller (iMC).

System 100 includes DIMM (dual inline memory module) 150, which represents a surface mount memory module. A surface mount memory module other than a DIMM can have the pin and pad footprint described. Memory device 130 represents the memory devices mounted on DIMM 150.

Memory device 130 includes array 140, which represents the memory array to store data. Memory device 130 includes decoder 136 to decode commands and register 134 to store configuration information. In one example, register 134 is a mode register. The configuration of register 134 controls the mode of operation of memory device 130.

Memory device 130 includes column DEC (decoder) 142 to manage access to specific columns and bits of memory. Memory device 130 includes row DEC (decoder) 144 to manage access to selected rows of memory.

I/O (input/output) 112 represents a hardware interface of host 110 to couple to I/O (input/output) 152 of DIMM 150. I/O 132 represents the hardware interface of memory device 130 to couple to the signals on DIMM 150. The interface includes CA (command/address) 162, which represents signal lines for a command and address bus. The CA bus is a unidirectional bus from controller 120 to memory device 130.

The interface includes DQ (data) 164, which represents signal lines for a data bus. The DQ bus is a bidirectional bus allowing host 110 and memory device 130 to exchange data with each other. The interface includes control signals (CTRL) 166, which represent a management bus, such as an I3C or M3C (memory module management control) bus, or other control signals or feedback signals associated with operation of DQ 164 or CA 162.

In one example, controller 120 includes CMD (command) control 122, which represents logic in controller 120 to generate and send commands to memory device 130. The commands from controller 120 generate access operations to the memory by host. Examples of access operations including read transactions and write transactions.

In one example, I/O 112 includes pad footprints 154 having specific shape and layout on the surface of the system board of host 110 to improve memory signaling. In one example, I/O 152 includes connector pin shapes represented by connector pins 156 that correspond to pad footprints 154.

In one example, I/O 112 and I/O 152 represents a connector to surface mount DIMM 150 to a system board (e.g., a motherboard) of host 110. The connector includes a housing that holds the signal pins and the ground pins. The pins couple the pads on the system board to corresponding pads on the DIMM board. The system board and the DIMM board are PCBs (printed circuit boards).

In one example, the signal pads on the system board have a circular shape to receive circular pin foot end tabs of the corresponding signal pins of the connector. In one example, the ground pads also have a circular shape for a circular pin foot end tab of the ground pins. In one example, a signal pad is disposed between two ground pins.

In one example, the ground pads on the system board have multiple ground vias that are offset from a center line of the ground pad. Offsetting the ground vias from the center line enables routing signal lines under the ground pads on subsurface layers of the host system board. In one example, the ground pads have four ground vias, one at each "corner" of the ground pad. It will be understood that reference to vias at the corners refers to the concept that the four ground vias are disposed at what would be the four corners of a rectangle, whether or not the ground pad is rectangular in shape or some other shape.

The descriptions below have examples of other ground pad shapes. The other ground pad shapes can still be considered to have ground vias at the "corners" in the sense that the ground vias can form a rectangle.

In one example, pad footprints 154 for the signal pads include capacitive stubs that extend from the signal pad. The capacitive stubs are non-routing in the sense that they do not convey the signal to another component; rather, the stub merely extends the shape of the signal pad to increase capacitance of the signal pad to offset the inductive loading of the signal traces.

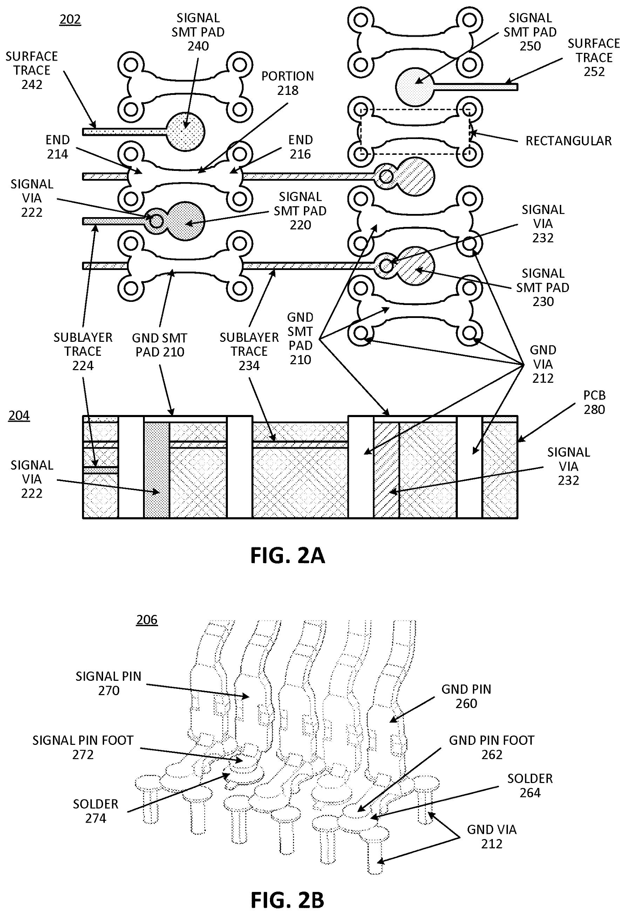

**Figure 2A** is a block diagram of an example of a ground pad footprint. System 202 illustrates ground pads that have two circular portions (end 214 and end 216) connected by a rectangular portion (portion 218).

System 202 also illustrates circular signal pads. Each signal pad is nested between two ground pads. It will be understood that the features are not necessarily all to scale, and different scale or configurations of the shapes illustrated can be implemented.

Ground (GND) surface mount (SMT) pad 210 ("ground pad 210") represents a ground pad on a surface of a system board. Ground pad 210 is composed of a conductive material having the footprint illustrated. It will be understood that the rectangular portion that connects the two circular portions is not necessarily a perfect rectangle. Specifically in system 202, the sides of the rectangle connecting the two circular portions curve toward the center. Such a curve can provide better spacing for the circular signal pads. Alternatively, the rectangular portion can have straight edges.

As illustrated, ground pad 210 has four ground (GND) vias 212. Ground vias 212 can be said to be at the four corners of ground pad 210, as represented by the rectangular dashed line.

Signal surface mount (SMT) pad 220 illustrates a circular signal pad. Signal via 222 represents a through-hole via to pass the signal line to a sublayer, as illustrated by sublayer trace 224. Signal surface mount (SMT) pad 240 illustrates a circular signal pad with surface trace 242. Signal surface mount (SMT) pad 250 also illustrates a circular signal pad with surface trace 252, illustrating that the surface traces can be routing in different directions.

Signal surface mount (SMT) pad 230 illustrates a circular signal pad with sublayer trace 234 from signal via 232. It will be observed that sublayer trace 234 can pass under one of the ground pads, passing between the ground vias and directly under the ground pad. In one example, signal via 232 is right off of the circular signal pad. In one example, signal via 232 is directly under the circular signal pad.

In one example, to route signal traces into and through the connector pin field represented by system 202, the traces can be routed next to the signal transition vias. Using four ground vias 212 per ground pad 210 along with the circular signal pads, system 202 allows for the routing of sublayer traces to pass under the ground pads for more separation between signal traces and vias.

With the changes to the pins and surface mount pads, system 202 supports a memory module connector that has different pins and is capable of using the same connector housing. Additionally, the basic layout on the system board or motherboard for the surface mount area and basic layout of the pads can be the same as prior memory modules, just with different pad shaping, and enabling improve routing for the increasing density of signals.

Testing indicates that the layout of system 202 provides improved impedance over a traditional DIMM surface mount layout. Additionally, the testing illustrates improvements in signaling, with crosstalk reduction of up to 3 dB over traditional layouts.

View 204 illustrates a side cutaway view of system 202, where the crosshatching represents PCB (printed circuit board) 280. The scale is not necessarily representative of an actual implementation; rather, certain features are emphasized. Ground vias 212 are illustrated as passing from the surface mount pad through PCB 280. Similarly, signal via 232 and signal via 232 can be seen extending through the layers of PCB 280. Sublayer trace 234 represents a sublayer trace extending under one of the ground pads. Sublayer trace 224 represents a sublayer trace in a different sublayer of PCB 280, to illustrate that there can be many layers of the board.

**Figure 2B** is a diagram of an example of a ground pin foot for the ground pad footprint of Figure 2A. System 206 is a perspective view of connector pins connected to the surface pads on the system board.

Ground vias 212 illustrate through-hole vias extending through the system board from the ground pad on the surface of the system board. Ground (GND) pin 260 represents a pin secured in a connector housing (not specifically illustrated). Ground pin 260 has ground (GND) pin foot 262, which has a rectangular portion, the foot portion, that extends horizontally away from the vertical portion of the pin. The foot extends horizontally, and is the portion that is secured to the ground pad through solder 264. Ground pin foot 262 has a circular end tab at the end of the ground pin foot.

Signal pin 270 represents a pin secured in the connector housing. Signal pin 270 has signal pin foot 272, which does not have a rectangular segment, just the circular end tab. Thus, ground pin foot 262 is longer than signal pin foot 272. It can be observed that signal pin foot 272 is connected to the signal pad via solder 274. The signal pad is nested between two ground pads.

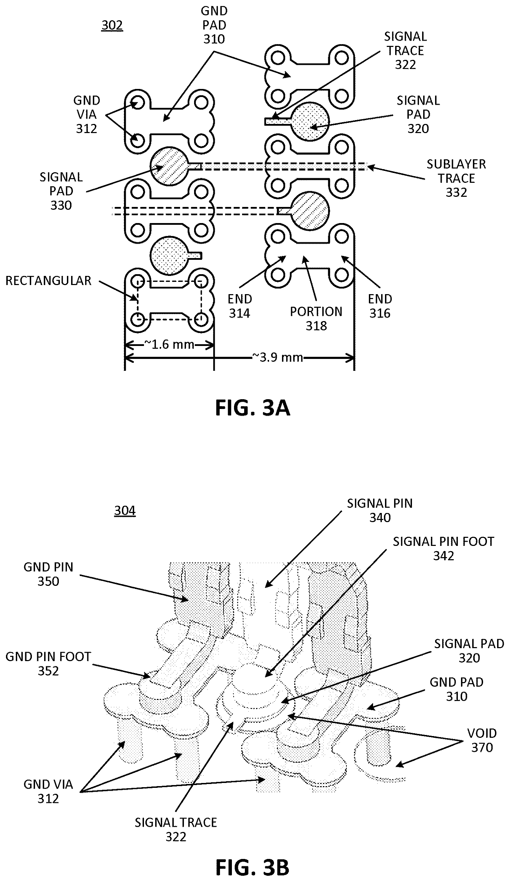

**Figure 3A** is a block diagram of an example of a reduced length ground pad footprint and signal footprint. System 302 illustrates ground pads that have a circular end (end 314), a rectangular end (end 316), and a rectangular portion (318) that connects end 314 to end 316.

System 302 also illustrates circular signal pads. Each signal pad is nested between two ground pads. It will be understood that the features are not necessarily all to scale, and different scale or configurations of the shapes illustrated can be implemented.

Ground (GND) pad 310 represents a ground pad on a surface of a system board. Ground pad 310 is composed of a conductive material having the footprint illustrated. It will be understood that the rectangular portion that connects the two circular portions is not necessarily a perfect rectangle.

As illustrated, ground pad 310 has four ground (GND) vias 312. Ground vias 312 can be said to be at the four corners of ground pad 310, as represented by the rectangular dashed line.

Signal pad 320 illustrates a circular signal pad with surface signal trace 322. Signal pad 330 illustrates a circular signal pad with sublayer trace 332. It will be understood that the signal via from signal pad 330 to sublayer trace 332 is not specifically illustrated. Sublayer trace 332 can pass under the ground pad, between the ground vias.

System 302 illustrates an example of shorter surface mount ground pads. For example, with traditional, rectangular ground pins each have a length (with ground vias) of approximately 2.7 mm, where ground pads 310 with its ground vias 312 has a length of approximately 1.6 mm.

Where a traditional connector has a total width, from the two rows of pads and the space between the two rows, of approximately 6.8 mm, system 302 can turn the pins under the connector housing. Thus, the total width of the two rows of pads and the space between the rows can be approximately 3.9 mm, allowing closer spacing of DIMMs on a board. Thus, the connector can be referred to as a slim memory module edge connector.

Testing indicates that the layout of system 302 provides improved impedance over a traditional DIMM surface mount layout. Additionally, the testing illustrates improvements in signaling, with crosstalk reduction of up to 3 dB over traditional layouts.

**Figure 3B** is a diagram of an example of a ground pin foot for the ground pad footprint and signal pin foot for the signal pad footprint of Figure 3A. System 304 is a perspective view of connector pins for a slim memory module connector, with the pins connected to the surface pads on the system board.

Ground vias 312 illustrate through-hole vias extending through the system board from the ground pad on the surface of the system board. Ground (GND) pin 350 represents a pin secured in a connector housing (not specifically illustrated). Ground pin 350 has ground (GND) pin foot 352, which has a rectangular portion, the foot portion, that extends horizontally away from the vertical portion of the pin. The foot extends horizontally, and is the portion that is secured to the ground pad through solder 354. Ground pin foot 352 has a circular end tab at the end of the ground pin foot.

Signal pin 340 represents a pin secured in the connector housing. Signal pin 340 has signal pin foot 342, which does not have a rectangular segment, just the circular end tab. Thus, ground pin foot 352 is longer than signal pin foot 342. It can be observed that signal pin foot 342 is connected to signal pad 320 via solder 344. Signal trace 322 extends off signal pad 320. Signal pad 320 is nested between two ground pads. As illustrated, ground pin foot 352 can be longer than signal pin foot 342.

In one example, the circular foot tabs can vary in size for different system implementations. In one example, system 304 has void 370 in the system board can be used to adjust impedance and crosstalk. The size of void 370 can be changed in size for the specific implementation of the connector.

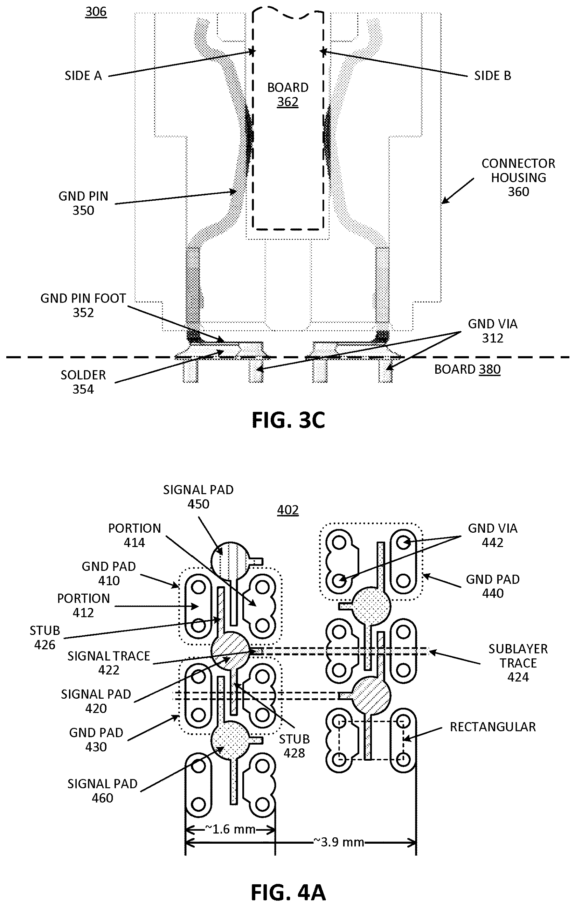

**Figure 3C** is a diagram of an example of a DIMM connector with pins turned under the connector housing. System 306 illustrates connector housing 360 for the connector.

Connector housing 360 secures ground pin 350. The pins in connector housing 360 have a portion that protrudes from the housing to electrically connect to corresponding pads on board 362. Board 362 represents a PCB for the memory module. The pads on board 362 are not specifically illustrated, but it will be understood that Side A and Side B have pads to make contact with corresponding pads on system board 380.

As illustrated, ground pin 350 has ground (GND) pin foot 352 that turns under connector housing 360, instead of turning out to extend away from connector housing 360. The bend of the pins aligns the pin feet to the surface mount pads. System 306 illustrates ground pin foot 352 coupled to the surface mount pad with solder 354. Ground vias 312 are illustrated extending into board 380.

By bending the foot of the pin under the connector housing, the connectors can be placed closer on the motherboard to each other, which allows reducing the trace route lengths. Turning the pins underneath the connector housing can be referred to as turning the pin toward the inside of the connector. Additionally, the trace routing can be directly under the ground surface mount pads with ground pads at the corners of the ground pad, offset from the center line of the ground pad. Turning the pins under the housing can reduce crosstalk and improve signal integrity as well as improving impedance on the signal lines.

**Figure 4A** is a block diagram of an example of a reduced length ground pad footprint and signal footprint with capacitive stubs. System 402 illustrates ground pads that have a circular end (portion 414) and a rectangular end (portion 412).

There is no surface mount portion connecting portion 414 to portion 412. Rather, the two surface mount portions separately connect to the ground plane through ground vias. Thus, the ground pads can be said to have physically separated portions, referring to the physical separation of the surface mount portions. The surface mount portions are not physically connected but are electrically connected through the ground plane.

System 402 also illustrates circular signal pads. Each signal pad is nested between two ground pads. It will be understood that the features are not necessarily all to scale, and different scale or configurations of the shapes illustrated can be implemented.

Ground (GND) pad 410 represents a ground pad on a surface of a system board. Ground pad 410 has portions composed of a conductive material having the footprint illustrated. As illustrated, ground pad 410 has four ground (GND) vias, not specifically labeled, two vias for portion 412 and two vias for portion 414.

System 402 illustrates ground (GND) pad 440 with ground pads 442. Ground vias 442 can be said to be at the four corners of ground pad 440, as represented by the rectangular dashed line on the other ground pad.

Signal pad 420 illustrates a circular signal pad with signal trace 422. Signal trace 422 can extend to sublayer trace 424 with a signal via that is not specifically illustrated. Sublayer trace 424 can pass under the ground pad across from signal pad 420, the sublayer trace passing between the ground vias.

System 402 illustrates an example of shorter surface mount ground pads. For example, with traditional, rectangular ground pins each have a length (with ground vias) of approximately 2.7 mm, where ground pads 410 with its ground vias 412 has a length of approximately 1.6 mm.

Where a traditional connector has a total width, from the two rows of pads and the space between the two rows, of approximately 6.8 mm, system 402 can turn the pins under the connector housing. Thus, the total width of the two rows of pads and the space between the rows can be approximately 3.9 mm, allowing closer spacing of DIMMs on a board. Thus, the connector can be referred to as a slim memory module edge connector.

System 402 illustrates signal pad 450 on one side of ground pad 410, signal pad 420 on the other side of ground pad 410, between ground pad 410 and ground pad 430. Ground pad 430 has signal pad 420 on one side and signal pad 460 on the other side.

The various signal pads are illustrated to represent that system 402 has capacitive stubs extending from the signal pads. More specifically, signal pad 420 has stub 426 extending between portion 412 and portion 414 of ground pad 410, extending toward signal pad 450. Signal pad 420 has stub 428 extending between the two portions of ground pad 430, extending toward signal pad 460. It will be understood that stub 426 and stub 428 are non-signal traces, unlike signal trace 422, which exchanges signals between signal pad 420 and other components.

The circular surface mount pads with stub extensions under the ground pins provides capacitive compensation, which reduces crosstalk. The capacitive stub structures can be modulated to adjust crosstalk benefits for specific implementations.

Testing indicates that the layout of system 402 provides improved impedance over a traditional DIMM surface mount layout. Additionally, the testing illustrates improvements in signaling, with crosstalk reduction of up to 3 dB over traditional layouts.

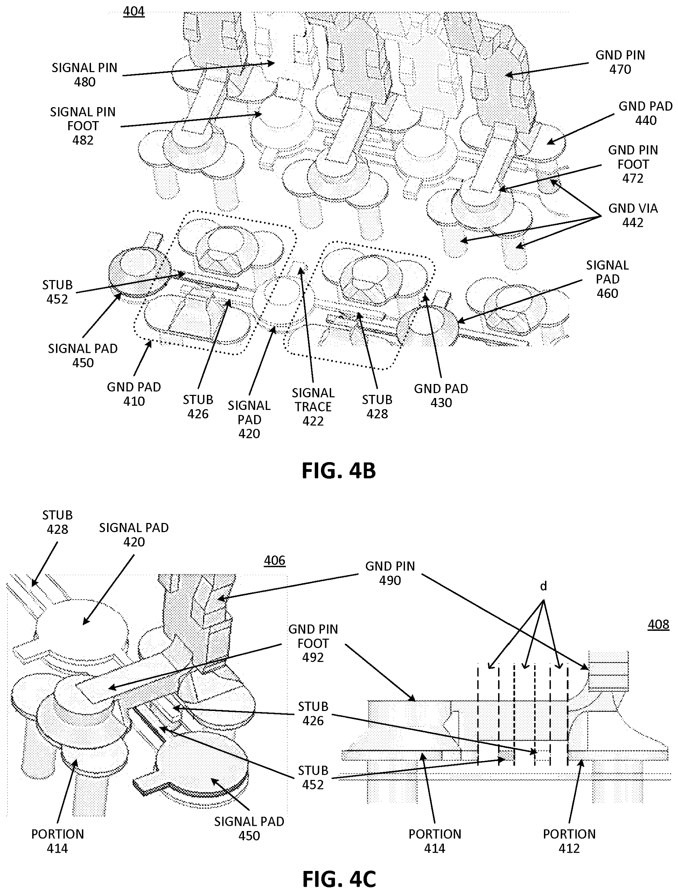

**Figure 4B** is a diagram of an example of a ground pin foot for the ground pad footprint and signal pin foot for the signal pad footprint of Figure 4A. System 404 illustrates a perspective view with ground pads and signal pads with circular portions, and the signal pads have capacitive stubs.

System 404 illustrates signal pad 450 with stub 452 that extends through ground pad 410 toward signal pad 420. Signal pad 420 has stub 426 extending through ground pad 410 toward signal pad 450 and stub 428 extending through ground pad 430 toward signal pad 460.

System 404 illustrates signal pin 480 having signal pin foot 482 bent under the connector housing to connect to the surface mount signal pad. Ground pin 470 represents a ground pin of the connector housing, also bent under the housing. Ground pin 470 has ground pin foot 472 to connect to ground pad 440. Ground pad 440 has ground vias 442.

**Figure 4C** is a diagram of an example of a cutaway view of Figure 4B. View 406 illustrates a perspective view of ground pin 490 that connects to ground pad 410. Ground pin 490 has ground pin foot 492 that extends between portion 412 and portion 414. View 406 illustrates that signal pad 420 has stub 428 extending away from the signal pad, as well as stub 426 that extends under ground pin foot 492 toward signal pad 450. Signal pad 450 has stub 452 that extends under ground pin foot 492 toward signal pad 420.

View 408 illustrates a side cutaway view of view 406. Specifically, stub 426 and stub 452 have rectangular cross sections. In one example, stub 452 is separated from portion 414 and from stub 426 by a distance 'd'. In one example, stub 426 is separate from stub 452 and from portion 412 by a distance 'd'. In one example, the distance 'd' (e.g., 3 mil) is a design rule.

While not specifically illustrated, it will be understood that the solder mask of the PCB will cover stub 426, stub 428, and stub 452. Thus, the conductive stubs will be covered by a nonconductive coating that electrically separates it from the ground pin.

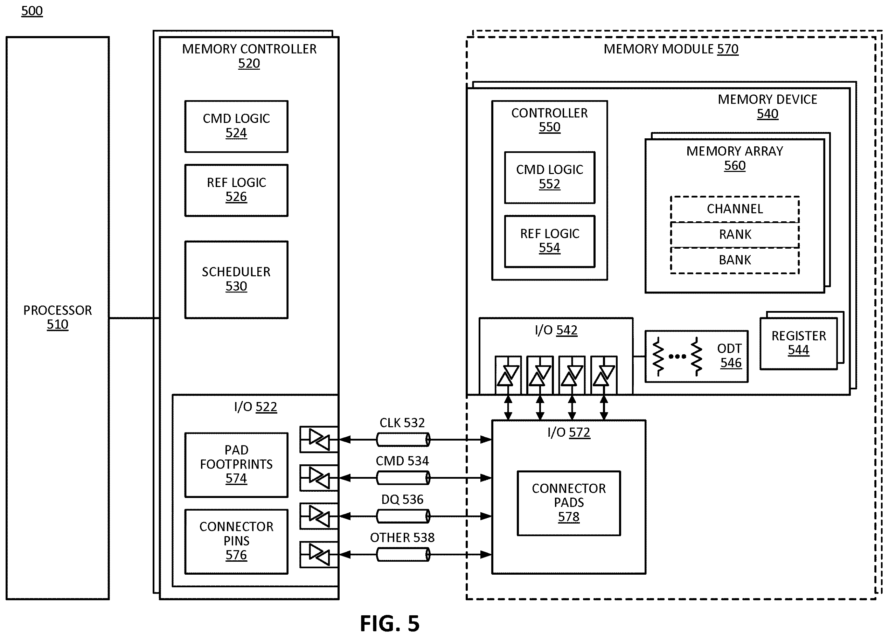

**Figure 5** is a block diagram of an example of a memory subsystem in which a DIMM connector can be implemented. System 500 includes a processor and elements of a memory subsystem in a computing device. System 500 represents a system in accordance with an example of system 100, system 202, system 302, or system 402.

In one example, system 500 includes I/O 572, which is the I/O for memory module 570. I/O 542 connects to I/O 522 through I/O 572. In one example, I/O 522 includes pad footprints 574 having specific shape and layout on the surface of the system board of the host (illustrated in memory controller 520) to improve memory signaling. In one example, I/O 572 includes connector pin shapes represented by connector pins 576 that correspond to pad footprints 574. The pads and pins can be in accordance with any example herein.

Processor 510 represents a processing unit of a computing platform that may execute an operating system (OS) and applications, which can collectively be referred to as the host or the user of the memory. The OS and applications execute operations that result in memory accesses. Processor 510 can include one or more separate processors. Each separate processor can include a single processing unit, a multicore processing unit, or a combination. The processing unit can be a primary processor such as a CPU (central processing unit), a peripheral processor such as a GPU (graphics processing unit), or a combination. Memory accesses may also be initiated by devices such as a network controller or hard disk controller. Such devices can be integrated with the processor in some systems or attached to the processer via a bus (e.g., PCI express), or a combination. System 500 can be implemented as an SOC (system on a chip), or be implemented with standalone components.

Reference to memory devices can apply to different memory types. Memory devices often refers to volatile memory technologies. Volatile memory is memory whose state (and therefore the data stored on it) is indeterminate if power is interrupted to the device. Nonvolatile memory refers to memory whose state is determinate even if power is interrupted to the device. Dynamic volatile memory requires refreshing the data stored in the device to maintain state. One example of dynamic volatile memory includes DRAM (dynamic random-access memory), or some variant such as synchronous DRAM (SDRAM). A memory subsystem as described herein may be compatible with a number of memory technologies, such as DDR4 (double data rate version 4, JESD79-4, originally published in September 2012 by JEDEC (Joint Electron Device Engineering Council, now the JEDEC Solid State Technology Association), LPDDR4 (low power DDR version 4, JESD209-4, originally published by JEDEC in August 2014), WIO2 (Wide I/O 2 (WideIO2), JESD229-2, originally published by JEDEC in August 2014), DDR5 (DDR version 5, originally published by JEDEC in July 2020), LPDDR5 (LPDDR version 5, JESD209-5, originally published by JEDEC in February 2019), or others or combinations of memory technologies, and technologies based on derivatives or extensions of such specifications.

Memory controller 520 represents one or more memory controller circuits or devices for system 500. Memory controller 520 represents control logic that generates memory access commands in response to the execution of operations by processor 510. Memory controller 520 accesses one or more memory devices 540. Memory devices 540 can be DRAM devices in accordance with any referred to above. In one example, memory devices 540 are organized and managed as different channels, where each channel couples to buses and signal lines that couple to multiple memory devices in parallel. Each channel is independently operable. Thus, each channel is independently accessed and controlled, and the timing, data transfer, command and address exchanges, and other operations are separate for each channel. Coupling can refer to an electrical coupling, communicative coupling, physical coupling, or a combination of these. Physical coupling can include direct contact. Electrical coupling includes an interface or interconnection that allows electrical flow between components, or allows signaling between components, or both. Communicative coupling includes connections, including wired or wireless, that enable components to exchange data.

In one example, settings for each channel are controlled by separate mode registers or other register settings. In one example, each memory controller 520 manages a separate memory channel, although system 500 can be configured to have multiple channels managed by a single controller, or to have multiple controllers on a single channel. In one example, memory controller 520 is part of host processor 510, such as logic implemented on the same die or implemented in the same package space as the processor.

Memory controller 520 includes I/O interface logic 522 to couple to a memory bus, such as a memory channel as referred to above. I/O interface logic 522 (as well as I/O interface logic 542 of memory device 540) can include pins, pads, connectors, signal lines, traces, or wires, or other hardware to connect the devices, or a combination of these. I/O interface logic 522 can include a hardware interface. As illustrated, I/O interface logic 522 includes at least drivers/transceivers for signal lines. Commonly, wires within an integrated circuit interface couple with a pad, pin, or connector to interface signal lines or traces or other wires between devices. I/O interface logic 522 can include drivers, receivers, transceivers, or termination, or other circuitry or combinations of circuitry to exchange signals on the signal lines between the devices. The exchange of signals includes at least one of transmit or receive. While shown as coupling I/O 522 from memory controller 520 to I/O 542 of memory device 540, it will be understood that in an implementation of system 500 where groups of memory devices 540 are accessed in parallel, multiple memory devices can include I/O interfaces to the same interface of memory controller 520. In an implementation of system 500 including one or more memory modules 570, I/O 542 can include interface hardware of the memory module in addition to interface hardware on the memory device itself. Other memory controllers 520 will include separate interfaces to other memory devices 540.

The bus between memory controller 520 and memory devices 540 can be implemented as multiple signal lines coupling memory controller 520 to memory devices 540. The bus may typically include at least clock (CLK) 532, command/address (CMD) 534, and write data (DQ) and read data (DQ) 536, and zero or more other signal lines 538. In one example, a bus or connection between memory controller 520 and memory can be referred to as a memory bus. In one example, the memory bus is a multi-drop bus. The signal lines for CMD can be referred to as a "C/A bus" (or ADD/CMD bus, or some other designation indicating the transfer of commands (C or CMD) and address (A or ADD) information) and the signal lines for write and read DQ can be referred to as a "data bus." In one example, independent channels have different clock signals, C/A buses, data buses, and other signal lines. Thus, system 500 can be considered to have multiple "buses," in the sense that an independent interface path can be considered a separate bus. It will be understood that in addition to the lines explicitly shown, a bus can include at least one of strobe signaling lines, alert lines, auxiliary lines, or other signal lines, or a combination. It will also be understood that serial bus technologies can be used for the connection between memory controller 520 and memory devices 540. An example of a serial bus technology is 8B10B encoding and transmission of high-speed data with embedded clock over a single differential pair of signals in each direction. In one example, CMD 534 represents signal lines shared in parallel with multiple memory devices. In one example, multiple memory devices share encoding command signal lines of CMD 534, and each has a separate chip select (CS_n) signal line to select individual memory devices.

It will be understood that in the example of system 500, the bus between memory controller 520 and memory devices 540 includes a subsidiary command bus CMD 534 and a subsidiary bus to carry the write and read data, DQ 536. In one example, the data bus can include bidirectional lines for read data and for write/command data. In another example, the subsidiary bus DQ 536 can include unidirectional write signal lines for write and data from the host to memory, and can include unidirectional lines for read data from the memory to the host. In accordance with the chosen memory technology and system design, other signals 538 may accompany a bus or sub bus, such as strobe lines DQS. Based on design of system 500, or implementation if a design supports multiple implementations, the data bus can have more or less bandwidth per memory device 540. For example, the data bus can support memory devices that have either a x4 interface, a x8 interface, a x16 interface, or other interface. The convention "xW," where W is an integer that refers to an interface size or width of the interface of memory device 540, which represents a number of signal lines to exchange data with memory controller 520. The interface size of the memory devices is a controlling factor on how many memory devices can be used concurrently per channel in system 500 or coupled in parallel to the same signal lines. In one example, high bandwidth memory devices, wide interface devices, or stacked memory configurations, or combinations, can enable wider interfaces, such as a x128 interface, a x256 interface, a x512 interface, a x1024 interface, or other data bus interface width.

In one example, memory devices 540 and memory controller 520 exchange data over the data bus in a burst, or a sequence of consecutive data transfers. The burst corresponds to a number of transfer cycles, which is related to a bus frequency. In one example, the transfer cycle can be a whole clock cycle for transfers occurring on a same clock or strobe signal edge (e.g., on the rising edge). In one example, every clock cycle, referring to a cycle of the system clock, is separated into multiple unit intervals (UIs), where each UI is a transfer cycle. For example, double data rate transfers trigger on both edges of the clock signal (e.g., rising and falling). A burst can last for a configured number of UIs, which can be a configuration stored in a register, or triggered on the fly. For example, a sequence of eight consecutive transfer periods can be considered a burst length eight (BL8), and each memory device 540 can transfer data on each UI. Thus, a x8 memory device operating on BL8 can transfer 64 bits of data (8 data signal lines times 8 data bits transferred per line over the burst). It will be understood that this simple example is merely an illustration and is not limiting.

Memory devices 540 represent memory resources for system 500. In one example, each memory device 540 is a separate memory die. In one example, each memory device 540 can interface with multiple (e.g., 2) channels per device or die. Each memory device 540 includes I/O interface logic 542, which has a bandwidth determined by the implementation of the device (e.g., x16 or x8 or some other interface bandwidth). I/O interface logic 542 enables the memory devices to interface with memory controller 520. I/O interface logic 542 can include a hardware interface, and can be in accordance with I/O 522 of memory controller, but at the memory device end. In one example, multiple memory devices 540 are connected in parallel to the same command and data buses. In another example, multiple memory devices 540 are connected in parallel to the same command bus, and are connected to different data buses. For example, system 500 can be configured with multiple memory devices 540 coupled in parallel, with each memory device responding to a command, and accessing memory resources 560 internal to each. For a Write operation, an individual memory device 540 can write a portion of the overall data word, and for a Read operation, an individual memory device 540 can fetch a portion of the overall data word. The remaining bits of the word will be provided or received by other memory devices in parallel.

In one example, memory devices 540 are disposed directly on a motherboard or host system platform (e.g., a PCB (printed circuit board) or substrate on which processor 510 is disposed) of a computing device. In one example, memory devices 540 can be organized into memory modules 570. In one example, memory modules 570 represent dual inline memory modules (DIMMs). In one example, memory modules 570 represent other organization of multiple memory devices to share at least a portion of access or control circuitry, which can be a separate circuit, a separate device, or a separate board from the host system platform. Memory modules 570 can include multiple memory devices 540, and the memory modules can include support for multiple separate channels to the included memory devices disposed on them. In another example, memory devices 540 may be incorporated into the same package as memory controller 520, such as by techniques such as multi-chip-module (MCM), package-on-package, through-silicon via (TSV), or other techniques or combinations. Similarly, in one example, multiple memory devices 540 may be incorporated into memory modules 570, which themselves may be incorporated into the same package as memory controller 520. It will be appreciated that for these and other implementations, memory controller 520 may be part of host processor 510.

Memory devices 540 each include one or more memory arrays 560. Memory array 560 represents addressable memory locations or storage locations for data. Typically, memory array 560 is managed as rows of data, accessed via wordline (rows) and bitline (individual bits within a row) control. Memory array 560 can be organized as separate channels, ranks, and banks of memory. Channels may refer to independent control paths to storage locations within memory devices 540. Ranks may refer to common locations across multiple memory devices (e.g., same row addresses within different devices) in parallel. Banks may refer to sub-arrays of memory locations within a memory device 540. In one example, banks of memory are divided into sub-banks with at least a portion of shared circuitry (e.g., drivers, signal lines, control logic) for the sub-banks, allowing separate addressing and access. It will be understood that channels, ranks, banks, sub-banks, bank groups, or other organizations of the memory locations, and combinations of the organizations, can overlap in their application to physical resources. For example, the same physical memory locations can be accessed over a specific channel as a specific bank, which can also belong to a rank. Thus, the organization of memory resources will be understood in an inclusive, rather than exclusive, manner.

In one example, memory devices 540 include one or more registers 544. Register 544 represents one or more storage devices or storage locations that provide configuration or settings for the operation of the memory device. In one example, register 544 can provide a storage location for memory device 540 to store data for access by memory controller 520 as part of a control or management operation. In one example, register 544 includes one or more Mode Registers. In one example, register 544 includes one or more multipurpose registers. The configuration of locations within register 544 can configure memory device 540 to operate in different "modes," where command information can trigger different operations within memory device 540 based on the mode. Additionally or in the alternative, different modes can also trigger different operation from address information or other signal lines depending on the mode. Settings of register 544 can indicate configuration for I/O settings (e.g., timing, termination or ODT (on-die termination) 546, driver configuration, or other I/O settings).

In one example, memory device 540 includes ODT 546 as part of the interface hardware associated with I/O 542. ODT 546 can be configured as mentioned above, and provide settings for impedance to be applied to the interface to specified signal lines. In one example, ODT 546 is applied to DQ signal lines. In one example, ODT 546 is applied to command signal lines. In one example, ODT 546 is applied to address signal lines. In one example, ODT 546 can be applied to any combination of the preceding. The ODT settings can be changed based on whether a memory device is a selected target of an access operation or a non-target device. ODT 546 settings can affect the timing and reflections of signaling on the terminated lines. Careful control over ODT 546 can enable higher-speed operation with improved matching of applied impedance and loading. ODT 546 can be applied to specific signal lines of I/O interface 542, 522 (for example, ODT for DQ lines or ODT for CA lines), and is not necessarily applied to all signal lines.

Memory device 540 includes controller 550, which represents control logic within the memory device to control internal operations within the memory device. For example, controller 550 decodes commands sent by memory controller 520 and generates internal operations to execute or satisfy the commands. Controller 550 can be referred to as an internal controller, and is separate from memory controller 520 of the host. Controller 550 can determine what mode is selected based on register 544, and configure the internal execution of operations for access to memory resources 560 or other operations based on the selected mode. Controller 550 generates control signals to control the routing of bits within memory device 540 to provide a proper interface for the selected mode and direct a command to the proper memory locations or addresses. Controller 550 includes command logic 552, which can decode command encoding received on command and address signal lines. Thus, command logic 552 can be or include a command decoder. With command logic 552, memory device can identify commands and generate internal operations to execute requested commands.

Referring again to memory controller 520, memory controller 520 includes command (CMD) logic 524, which represents logic or circuitry to generate commands to send to memory devices 540. The generation of the commands can refer to the command prior to scheduling, or the preparation of queued commands ready to be sent. Generally, the signaling in memory subsystems includes address information within or accompanying the command to indicate or select one or more memory locations where the memory devices should execute the command. In response to scheduling of transactions for memory device 540, memory controller 520 can issue commands via I/O 522 to cause memory device 540 to execute the commands. In one example, controller 550 of memory device 540 receives and decodes command and address information received via I/O 542 from memory controller 520. Based on the received command and address information, controller 550 can control the timing of operations of the logic and circuitry within memory device 540 to execute the commands. Controller 550 is responsible for compliance with standards or specifications within memory device 540, such as timing and signaling requirements. Memory controller 520 can implement compliance with standards or specifications by access scheduling and control.

Memory controller 520 includes scheduler 530, which represents logic or circuitry to generate and order transactions to send to memory device 540. From one perspective, the primary function of memory controller 520 could be said to schedule memory access and other transactions to memory device 540. Such scheduling can include generating the transactions themselves to implement the requests for data by processor 510 and to maintain integrity of the data (e.g., such as with commands related to refresh). Transactions can include one or more commands, and result in the transfer of commands or data or both over one or multiple timing cycles such as clock cycles or unit intervals. Transactions can be for access such as read or write or related commands or a combination, and other transactions can include memory management commands for configuration, settings, data integrity, or other commands or a combination.

Memory controller 520 typically includes logic such as scheduler 530 to allow selection and ordering of transactions to improve performance of system 500. Thus, memory controller 520 can select which of the outstanding transactions should be sent to memory device 540 in which order, which is typically achieved with logic much more complex that a simple first-in first-out algorithm. Memory controller 520 manages the transmission of the transactions to memory device 540, and manages the timing associated with the transaction. In one example, transactions have deterministic timing, which can be managed by memory controller 520 and used in determining how to schedule the transactions with scheduler 530.

In one example, memory controller 520 includes refresh (REF) logic 526. Refresh logic 526 can be used for memory resources that are volatile and need to be refreshed to retain a deterministic state. In one example, refresh logic 526 indicates a location for refresh, and a type of refresh to perform. Refresh logic 526 can trigger self-refresh within memory device 540, or execute external refreshes which can be referred to as auto refresh commands) by sending refresh commands, or a combination. In one example, controller 550 within memory device 540 includes refresh logic 554 to apply refresh within memory device 540. In one example, refresh logic 554 generates internal operations to perform refresh in accordance with an external refresh received from memory controller 520. Refresh logic 554 can determine if a refresh is directed to memory device 540, and what memory resources 560 to refresh in response to the command.

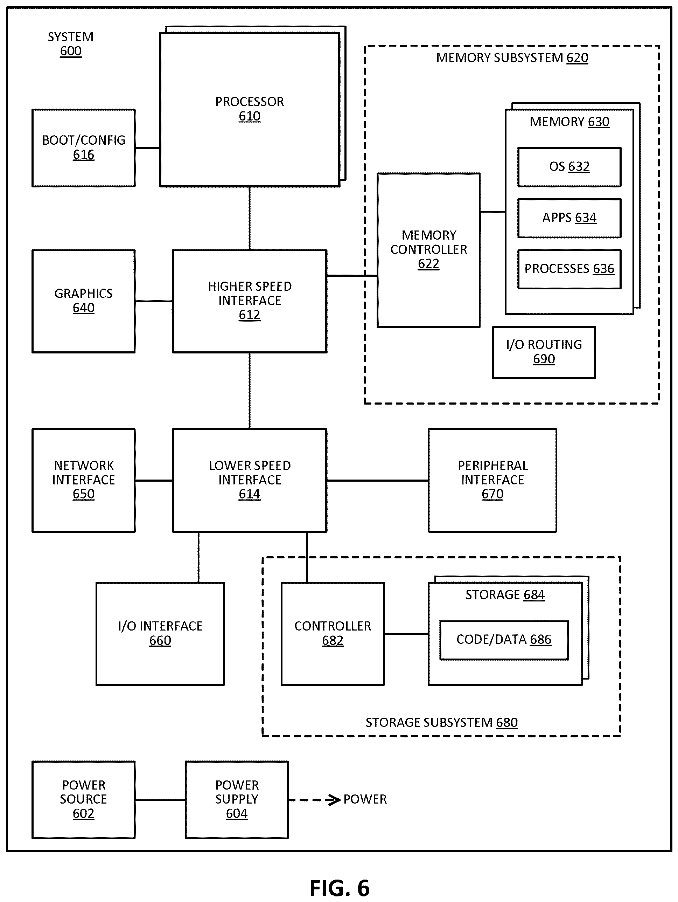

**Figure 6** is a block diagram of an example of a computing system in which a DIMM connector can be implemented. System 600 represents a computing device in accordance with any example herein, and can be a laptop computer, a desktop computer, a tablet computer, a server, a gaming or entertainment control system, embedded computing device, or other electronic device.

System 600 represents a system in accordance with an example of system 100, system 202, system 302, or system 402. In one example, system 600 includes I/O routing 690 in memory subsystem 620. I/O routing 690 represents pads and pins in accordance with any example herein. More specifically, I/O routing 690 includes pad footprints having specific shape and layout on the surface of the system board of the host to improve memory signaling and connector pin shapes represented by connector pins that correspond to the pad footprints.

System 600 includes processor 610 can include any type of microprocessor, central processing unit (CPU), graphics processing unit (GPU), processing core, or other processing hardware, or a combination, to provide processing or execution of instructions for system 600. Processor 610 can be a host processor device. Processor 610 controls the overall operation of system 600, and can be or include, one or more programmable general-purpose or special-purpose microprocessors, digital signal processors (DSPs), programmable controllers, application specific integrated circuits (ASICs), programmable logic devices (PLDs), or a combination of such devices.

System 600 includes boot/config 616, which represents storage to store boot code (e.g., basic input/output system (BIOS)), configuration settings, security hardware (e.g., trusted platform module (TPM)), or other system level hardware that operates outside of a host OS. Boot/config 616 can include a nonvolatile storage device, such as read-only memory (ROM), flash memory, or other memory devices.

In one example, system 600 includes interface 612 coupled to processor 610, which can represent a higher speed interface or a high throughput interface for system components that need higher bandwidth connections, such as memory subsystem 620 or graphics interface components 640. Interface 612 represents an interface circuit, which can be a standalone component or integrated onto a processor die. Interface 612 can be integrated as a circuit onto the processor die or integrated as a component on a system on a chip. Where present, graphics interface 640 interfaces to graphics components for providing a visual display to a user of system 600. Graphics interface 640 can be a standalone component or integrated onto the processor die or system on a chip. In one example, graphics interface 640 can drive a high definition (HD) display or ultra high definition (UHD) display that provides an output to a user. In one example, the display can include a touchscreen display. In one example, graphics interface 640 generates a display based on data stored in memory 630 or based on operations executed by processor 610 or both.

Memory subsystem 620 represents the main memory of system 600, and provides storage for code to be executed by processor 610, or data values to be used in executing a routine. Memory subsystem 620 can include one or more varieties of random-access memory (RAM) such as DRAM, 3DXP (three-dimensional crosspoint), or other memory devices, or a combination of such devices. Memory 630 stores and hosts, among other things, operating system (OS) 632 to provide a software platform for execution of instructions in system 600. Additionally, applications 634 can execute on the software platform of OS 632 from memory 630. Applications 634 represent programs that have their own operational logic to perform execution of one or more functions. Processes 636 represent agents or routines that provide auxiliary functions to OS 632 or one or more applications 634 or a combination. OS 632, applications 634, and processes 636 provide software logic to provide functions for system 600. In one example, memory subsystem 620 includes memory controller 622, which is a memory controller to generate and issue commands to memory 630. It will be understood that memory controller 622 could be a physical part of processor 610 or a physical part of interface 612. For example, memory controller 622 can be an integrated memory controller, integrated onto a circuit with processor 610, such as integrated onto the processor die or a system on a chip.

While not specifically illustrated, it will be understood that system 600 can include one or more buses or bus systems between devices, such as a memory bus, a graphics bus, interface buses, or others. Buses or other signal lines can communicatively or electrically couple components together, or both communicatively and electrically couple the components. Buses can include physical communication lines, point-to-point connections, bridges, adapters, controllers, or other circuitry or a combination. Buses can include, for example, one or more of a system bus, a Peripheral Component Interconnect (PCI) bus, a HyperTransport or industry standard architecture (ISA) bus, a small computer system interface (SCSI) bus, a universal serial bus (USB), or other bus, or a combination.

In one example, system 600 includes interface 614, which can be coupled to interface 612. Interface 614 can be a lower speed interface than interface 612. In one example, interface 614 represents an interface circuit, which can include standalone components and integrated circuitry. In one example, multiple user interface components or peripheral components, or both, couple to interface 614. Network interface 650 provides system 600 the ability to communicate with remote devices (e.g., servers or other computing devices) over one or more networks. Network interface 650 can include an Ethernet adapter, wireless interconnection components, cellular network interconnection components, USB (universal serial bus), or other wired or wireless standards-based or proprietary interfaces. Network interface 650 can exchange data with a remote device, which can include sending data stored in memory or receiving data to be stored in memory.

In one example, system 600 includes one or more input/output (I/O) interface(s) 660. I/O interface 660 can include one or more interface components through which a user interacts with system 600 (e.g., audio, alphanumeric, tactile/touch, or other interfacing). Peripheral interface 670 can include any hardware interface not specifically mentioned above. Peripherals refer generally to devices that connect dependently to system 600. A dependent connection is one where system 600 provides the software platform or hardware platform or both on which operation executes, and with which a user interacts.

In one example, system 600 includes storage subsystem 680 to store data in a nonvolatile manner. In one example, in certain system implementations, at least certain components of storage 680 can overlap with components of memory subsystem 620. Storage subsystem 680 includes storage device(s) 684, which can be or include any conventional medium for storing large amounts of data in a nonvolatile manner, such as one or more magnetic, solid state, NAND, 3DXP, or optical based disks, or a combination. Storage 684 holds code or instructions and data 686 in a persistent state (i.e., the value is retained despite interruption of power to system 600). Storage 684 can be generically considered to be a "memory," although memory 630 is typically the executing or operating memory to provide instructions to processor 610. Whereas storage 684 is nonvolatile, memory 630 can include volatile memory (i.e., the value or state of the data is indeterminate if power is interrupted to system 600). In one example, storage subsystem 680 includes controller 682 to interface with storage 684. In one example controller 682 is a physical part of interface 614 or processor 610, or can include circuits or logic in both processor 610 and interface 614.

Power source 602 provides power to the components of system 600. More specifically, power source 602 typically interfaces to one or multiple power supplies 604 in system 600 to provide power to the components of system 600. In one example, power supply 604 includes an AC to DC (alternating current to direct current) adapter to plug into a wall outlet. Such AC power can be renewable energy (e.g., solar power) power source 602. In one example, power source 602 includes a DC power source, such as an external AC to DC converter. In one example, power source 602 or power supply 604 includes wireless charging hardware to charge via proximity to a charging field. In one example, power source 602 can include an internal battery or fuel cell source.

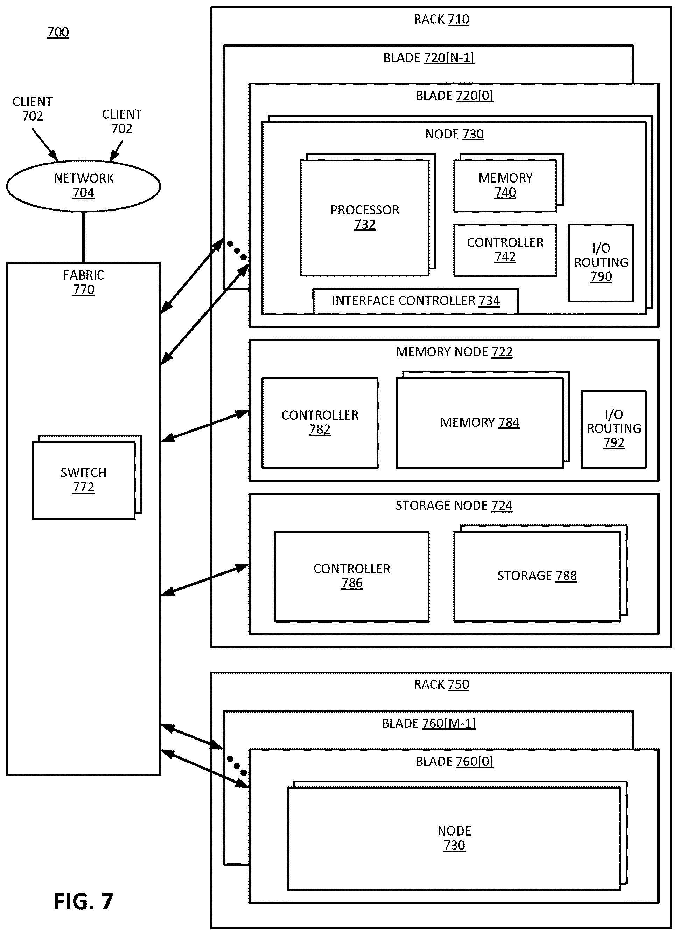

**Figure 7** is a block diagram of an example of a multi-node network in which a DIMM connector can be implemented. In one example, system 700 represents a data center. In one example, system 700 represents a server farm. In one example, system 700 represents a data cloud or a processing cloud.

Nodes 730 of system 700 represent a system in accordance with an example of system 100, system 202, system 302, or system 402. In one example, system 700 includes I/O routing 790 in node 730 and potentially I/O routing 792 in memory node 722. I/O routing 790 and I/O routing 792 represent pads and pins in accordance with any example herein. More specifically, the I/O routing includes pad footprints having specific shape and layout on the surface of the system board of the host to improve memory signaling and connector pin shapes represented by connector pins that correspond to the pad footprints.

One or more clients 702 make requests over network 704 to system 700. Network 704 represents one or more local networks, or wide area networks, or a combination. Clients 702 can be human or machine clients, which generate requests for the execution of operations by system 700. System 700 executes applications or data computation tasks requested by clients 702.

In one example, system 700 includes one or more racks, which represent structural and interconnect resources to house and interconnect multiple computation nodes. In one example, rack 710 includes multiple nodes 730. In one example, rack 710 hosts multiple blade components, blade 720[0], ..., blade 720[N-1], collectively blades 720. Hosting refers to providing power, structural or mechanical support, and interconnection. Blades 720 can refer to computing resources on printed circuit boards (PCBs), where a PCB houses the hardware components for one or more nodes 730. In one example, blades 720 do not include a chassis or housing or other "box" other than that provided by rack 710. In one example, blades 720 include housing with exposed connector to connect into rack 710. In one example, system 700 does not include rack 710, and each blade 720 includes a chassis or housing that can stack or otherwise reside in close proximity to other blades and allow interconnection of nodes 730.

System 700 includes fabric 770, which represents one or more interconnectors for nodes 730. In one example, fabric 770 includes multiple switches 772 or routers or other hardware to route signals among nodes 730. Additionally, fabric 770 can couple system 700 to network 704 for access by clients 702. In addition to routing equipment, fabric 770 can be considered to include the cables or ports or other hardware equipment to couple nodes 730 together. In one example, fabric 770 has one or more associated protocols to manage the routing of signals through system 700. In one example, the protocol or protocols is at least partly dependent on the hardware equipment used in system 700.

As illustrated, rack 710 includes N blades 720. In one example, in addition to rack 710, system 700 includes rack 750. As illustrated, rack 750 includes M blade components, blade 760[0], ..., blade 760[M-1], collectively blades 760. M is not necessarily the same as N; thus, it will be understood that various different hardware equipment components could be used, and coupled together into system 700 over fabric 770. Blades 760 can be the same or similar to blades 720. Nodes 730 can be any type of node and are not necessarily all the same type of node. System 700 is not limited to being homogenous, nor is it limited to not being homogenous.

The nodes in system 700 can include compute nodes, memory nodes, storage nodes, accelerator nodes, or other nodes. Rack 710 is represented with memory node 722 and storage node 724, which represent shared system memory resources, and shared persistent storage, respectively. One or more nodes of rack 750 can be a memory node or a storage node.

Nodes 730 represent examples of compute nodes. For simplicity, only the compute node in blade 720[0] is illustrated in detail. However, other nodes in system 700 can be the same or similar. At least some nodes 730 are computation nodes, with processor (proc) 732 and memory 740. A computation node refers to a node with processing resources (e.g., one or more processors) that executes an operating system and can receive and process one or more tasks. In one example, at least some nodes 730 are server nodes with a server as processing resources represented by processor 732 and memory 740.

Memory node 722 represents an example of a memory node, with system memory external to the compute nodes. Memory nodes can include controller 782, which represents a processor on the node to manage access to the memory. The memory nodes include memory 784 as memory resources to be shared among multiple compute nodes.

Storage node 724 represents an example of a storage server, which refers to a node with more storage resources than a computation node, and rather than having processors for the execution of tasks, a storage server includes processing resources to manage access to the storage nodes within the storage server. Storage nodes can include controller 786 to manage access to the storage 788 of the storage node.

In one example, node 730 includes interface controller 734, which represents logic to control access by node 730 to fabric 770. The logic can include hardware resources to interconnect to the physical interconnection hardware. The logic can include software or firmware logic to manage the interconnection. In one example, interface controller 734 is or includes a host fabric interface, which can be a fabric interface in accordance with any example described herein. The interface controllers for memory node 722 and storage node 724 are not explicitly shown.

Processor 732 can include one or more separate processors. Each separate processor can include a single processing unit, a multicore processing unit, or a combination. The processing unit can be a primary processor such as a CPU (central processing unit), a peripheral processor such as a GPU (graphics processing unit), or a combination. Memory 740 can be or include memory devices represented by memory 740 and a memory controller represented by controller 742.

In general with respect to the descriptions herein, in one aspect, a connector includes: a housing; multiple ground pins to couple first ground pads on a dual inline memory module (DIMM) board to second grounds pads on a system board; and multiple signal pins to couple first signal pads on the DIMM board to second signal pads on the system board, where the signal pins are separated by ground pins; wherein the signal pins have a pin foot having a circular end tab to connect to respective second signal pads on the system board.

In one example of the connector, the ground pins have a pin foot with a foot portion and a circular end tab extending from the foot portion. In accordance with any previous example of the connector, in one example, the ground pin foot is longer than the signal pin foot. In accordance with any previous example of the connector, in one example, the circular end tab of the pin foot of the signal pin is to connect to a circular signal pad nested between two ground pads. In accordance with any previous example of the connector, in one example, the second signal pads are to be located under the housing, with the signal pins bent under the housing to contact the second signal pads. In accordance with any previous example of the connector, in one example, the second ground pads are to be located under the housing, with the ground pins bent under the housing to contact the second ground pads.

In general with respect to the descriptions herein, in one aspect, a computer system includes: a motherboard including a first surface with first ground pads to couple to second ground pads of a dual inline memory module (DIMM) board and first signal pads to couple to second signal pads of the DIMM board, wherein the first signal pads have a circular shape; and a connector including: a housing; ground pins to couple the first ground pads to the second grounds pads; and signal pins to couple the first signal pads to the second signal pads; wherein the signal pins have a pin foot with the circular shape to connect to respective first signal pads having the circular shape.

In one example of the computer system, the first signal pads have a circular shape. In accordance with any previous example of the computer system, in one example, the first ground pads have a straight portion and a circular portion to connect with the ground pins, which have a pin foot with a straight portion and a circular end tab extending from the straight portion. In accordance with any previous example of the computer system, in one example, the ground pin foot is longer than the signal pin foot. In accordance with any previous example of the computer system, in one example, the pin foot of the signal pin is to connect to the circular signal pad nested between two ground pads. In accordance with any previous example of the computer system, in one example, the second signal pads are located under the housing, with the signal pins bent under the housing to contact the second signal pads. In accordance with any previous example of the computer system, in one example, the second ground pads are to be located under the housing, with the ground pins bent under the housing to contact the second ground pads. In accordance with any previous example of the computer system, in one example, the ground pads have a first circular portion, a second circular portion, and a rectangular portion connecting the first circular portion to the first circular portion. In accordance with any previous example of the computer system, in one example, the first circular portion is electrically connected to two through-hole vias to connect to a ground plane, one through-hole via on each side of the first circular portion, the through-hole vias offset from a center line of first ground pads, and the second circular portion is electrically connected to two through-hole vias to connect to the ground plane, one through-hole via on each side of the second circular portion, the through-hole vias offset from a center line of first ground pads. In accordance with any previous example of the computer system, in one example, the first ground pads have two physically separated portions on the first surface, a circular portion and a rectangular portion. In accordance with any previous example of the computer system, in one example, the circular portion is electrically connected to two through-hole vias to connect to a ground plane, one through-hole via on each side of the circular portion, the through-hole vias offset from a center line of first ground pads. In accordance with any previous example of the computer system, in one example, the rectangular portion is electrically connected to two through-hole vias to connect to a ground plane, one through-hole via on each side of the rectangular portion, the through-hole vias offset from a center line of first ground pads. In accordance with any previous example of the computer system, in one example, the first signal pads have a capacitive stub extending off the circular pin foot, the capacitive stub to extend between the two physically separated portions of an adjacent first ground pad. In accordance with any previous example of the computer system, in one example, the computer system includes a host processor device mounted on the motherboard. In accordance with any previous example of the computer system, in one example, the computer system includes a display communicatively coupled to a host processor of the motherboard. In accordance with any previous example of the computer system, in one example, the computer system includes a network interface communicatively coupled to a host processor of the motherboard. In accordance with any previous example of the computer system, in one example, the computer system includes a battery to power the computer system.

Flow diagrams as illustrated herein provide examples of sequences of various process actions. The flow diagrams can indicate operations to be executed by a software or firmware routine, as well as physical operations. A flow diagram can illustrate an example of the implementation of states of a finite state machine (FSM), which can be implemented in hardware and/or software. Although shown in a particular sequence or order, unless otherwise specified, the order of the actions can be modified. Thus, the illustrated diagrams should be understood only as examples, and the process can be performed in a different order, and some actions can be performed in parallel. Additionally, one or more actions can be omitted; thus, not all implementations will perform all actions.

To the extent various operations or functions are described herein, they can be described or defined as software code, instructions, configuration, and/or data. The content can be directly executable ("object" or "executable" form), source code, or difference code ("delta" or "patch" code). The software content of what is described herein can be provided via an article of manufacture with the content stored thereon, or via a method of operating a communication interface to send data via the communication interface. A machine readable storage medium can cause a machine to perform the functions or operations described, and includes any mechanism that stores information in a form accessible by a machine (e.g., computing device, electronic system, etc.), such as recordable/non-recordable media (e.g., read only memory (ROM), random access memory (RAM), magnetic disk storage media, optical storage media, flash memory devices, etc.). A communication interface includes any mechanism that interfaces to any of a hardwired, wireless, optical, etc., medium to communicate to another device, such as a memory bus interface, a processor bus interface, an Internet connection, a disk controller, etc. The communication interface can be configured by providing configuration parameters and/or sending signals to prepare the communication interface to provide a data signal describing the software content. The communication interface can be accessed via one or more commands or signals sent to the communication interface.

Various components described herein can be a means for performing the operations or functions described. Each component described herein includes software, hardware, or a combination of these. The components can be implemented as software modules, hardware modules, special-purpose hardware (e.g., application specific hardware, application specific integrated circuits (ASICs), digital signal processors (DSPs), etc.), embedded controllers, hardwired circuitry, etc.

Besides what is described herein, various modifications can be made to what is disclosed and implementations of the invention without departing from their scope. Therefore, the illustrations and examples herein should be construed in an illustrative, and not a restrictive sense. The scope of the invention should be measured solely by reference to the claims that follow.

## Claims

1. A connector comprising:
a housing;
multiple ground pins to couple first ground pads on a dual inline memory module (DIMM) board to second grounds pads on a system board; and
multiple signal pins to couple first signal pads on the DIMM board to second signal pads on the system board, where the signal pins are separated by ground pins;
wherein the signal pins have a pin foot having a circular end tab to connect to respective second signal pads on the system board.

2. The connector of claim 1, wherein the ground pins have a pin foot with a foot portion and a circular end tab extending from the foot portion.

3. The connector of claim 2, wherein the ground pin foot is longer than the signal pin foot.

4. The connector of claim 3, wherein the circular end tab of the pin foot of the signal pin is to connect to a circular signal pad nested between two ground pads.

5. The connector of any of claims 1 to 4, wherein the second signal pads are to be located under the housing, with the signal pins bent under the housing to contact the second signal pads.

6. The connector of claim 5, wherein the second ground pads are to be located under the housing, with the ground pins bent under the housing to contact the second ground pads.

7. A computer system comprising:
a system board including a first surface with first ground pads to couple to second ground pads of a dual inline memory module (DIMM) board and first signal pads to couple to second signal pads of the DIMM board, wherein the first signal pads have a circular shape; and
a connector in accordance with any of claims 1 to 6.

8. The computer system of claim 7, wherein the ground pads have a first circular portion, a second circular portion, and a rectangular portion connecting the first circular portion to the first circular portion.

9. The computer system of claim 8, wherein the first circular portion is electrically connected to two through-hole vias to connect to a ground plane, one through-hole via on each side of the first circular portion, the through-hole vias offset from a center line of first ground pads, and the second circular portion is electrically connected to two through-hole vias to connect to the ground plane, one through-hole via on each side of the second circular portion, the through-hole vias offset from a center line of first ground pads.

10. The computer system of any of claims 7 to 9, wherein the first ground pads have two physically separated portions on the first surface, a circular portion and a rectangular portion.

11. The computer system of claim 10, wherein the circular portion is electrically connected to two through-hole vias to connect to a ground plane, one through-hole via on each side of the circular portion, the through-hole vias offset from a center line of first ground pads.

12. The computer system of claim 10, wherein the rectangular portion is electrically connected to two through-hole vias to connect to a ground plane, one through-hole via on each side of the rectangular portion, the through-hole vias offset from a center line of first ground pads.

13. The computer system of claim 10, wherein the first signal pads have a capacitive stub extending off the circular pin foot, the capacitive stub to extend between the two physically separated portions of an adjacent first ground pad.

14. The computer system of any of claims 7 to 13, further comprising one or more of:
a host processor device mounted on the motherboard;
a display communicatively coupled to a host processor of the motherboard;
a network interface communicatively coupled to a host processor of the motherboard; or
a battery to power the computer system.
